# EUROPÄISCHE PATENTSCHRIFT

(11) **EP 2 595 126 B1**
(45) Veröffentlichungstag und Bekanntmachung des Hinweises auf die Patenterteilung: **06.03.2019**
(21) Anmeldenummer: 12153395.4
(22) Anmeldetag: 31.01.2012
(51) Int. Cl.: G08B 17/10, G08B 29/00

(54) **Gefahrenmelder zum Betrieb im Nuklearbereich, mit einer Heizung zum Beheizen typischerweise nichtstrahlungsfester Halbleiterbauelemente zur Erhöhung der funktionalen Lebensdauer**
Alarm for use in the nuclear field with a heating system for heating semiconductor elements that are not typically radiation resistant to improve functional service life
Dispositif d'alarme pour le fonctionnement dans le domaine nucléaire, doté d'un chauffage pour chauffer des composants semi-conducteurs typiquement non résistant aux rayonnements pour l'augmentation de la durée de vie fonctionnelle

(30) Priorität: 15.11.2011 DE 102011086424
(43) Veröffentlichungstag der Anmeldung: 22.05.2013
(73) Patentinhaber: Siemens Schweiz AG, 8047 Zürich (CH)
(72) Erfinder: Aebersold, Hans, 8906 Bonstetten (CH); Arnold, Martin, 5630 Muri (CH)
(74) Vertreter: Maier, Daniel Oliver

(56) Entgegenhaltungen:
- US-A- 5 270 551
- SAIGNÉSAIGNE F ET AL: "Experimental Procedure to Predict the Competition Between the Degradation Induced by Irradiation and Thermal Annealing of Oxide Trapped Charge in MOSFETs", IEEE TRANSACTIONS ON NUCLEAR SCIENCE, IEEE SERVICE CENTER, NEW YORK, NY, US, Bd. 47, Nr. 6, 1. Dezember 2000 (2000-12-01), XP011041893, ISSN: 0018-9499
- DUSSEAU L ET AL: "Prediction of low dose-rate effects in power metal oxide semiconductor field effect transistors based on isochronal annealing measurements", JOURNAL OF APPLIED PHYSICS, AMERICAN INSTITUTE OF PHYSICS. NEW YORK, US, Bd. 81, Nr. 5, 1. März 1997 (1997-03-01), Seite 2437, XP012041683, ISSN: 0021-8979, DOI: 10.1063/1.364251
- SAIGNÉSAIGNE F ET AL: "Prediction of the One-Year Thermal Annealing of Irradiated Commercial Devices Based on Experimental Isochronal Curves", IEEE TRANSACTIONS ON NUCLEAR SCIENCE, IEEE SERVICE CENTER, NEW YORK, NY, US, Bd. 47, Nr. 6, 1. Dezember 2000 (2000-12-01), XP011041894, ISSN: 0018-9499
- ELMAATI BENDADA ET AL: "Annealing of Irradiated-Induced defects in power MOSFETs", MICROELECTRONICS (ICM), 2009 INTERNATIONAL CONFERENCE ON, IEEE, PISCATAWAY, NJ, USA, 19. Dezember 2009 (2009-12-19), Seiten 236-239, XP031631884, ISBN: 978-1-4244-5814-1
- OHYAMA H ET AL: "Radiation source dependence of device performance degradation for 4H-SiC MESFETs", SUPERLATTICES AND MICROSTRUCTURES, ACADEMIC PRESS, LONDON, GB, Bd. 40, Nr. 4-6, 1. Oktober 2006 (2006-10-01), Seiten 632-637, XP024904903, ISSN: 0749-6036, DOI: 10.1016/J.SPMI.2006.09.009 [gefunden am 2006-10-01]
- VITALY DANCHENKO ET AL: "Activation Energies of Thermal Annealing of Radiation-Induced Damage in N- and P-Channels of CMOS Integrated Circuits", IEEE TRANSACTIONS ON NUCLEAR SCIENCE, Bd. 27, Nr. 6, 1. Januar 1980 (1980-01-01) , Seiten 1658-1664, XP55024634, ISSN: 0018-9499, DOI: 10.1109/TNS.1980.4331085
- VITALY DANCHENKO ET AL: "Activation Energies of Thermal Annealing of Radiation-Induced Damage in n- and p-channels of CMOS Integrated Circuits, Part II", IEEE TRANSACTIONS ON NUCLEAR SCIENCE, Bd. 28, Nr. 6, 1. Januar 1981 (1981-01-01) , Seiten 4407-4412, XP55024636, ISSN: 0018-9499, DOI: 10.1109/TNS.1981.4335739
- Xlao-Rul Tian ET AL: "Satellite remote-sensing technologies used in forest fire management", Journal of Forestry Research, vol. 16, 1 January 2005 (2005-01-01), pages 73-78, XP055259190,

## Beschreibung

Die Erfindung betrifft einen Gefahrenmelder, insbesondere einen Brandmelder, zum Betrieb in einem Bereich mit erhöhter radioaktiver Strahlendisposition, wobei der Gefahrenmelder zumindest eine Detektoreinheit zur Detektion zumindest einer Gefahrenkenngrösse, ein Halbleiterbauelement und weitere elektrische Bauelemente zumindest zur Ausgabe eines Meldersignals aufweist.

Die Erfindung betrifft weiterhin einen als linearen Rauchmelder ausgebildeten Gefahrenmelder mit einem Lichtsender zur Aussendung eines eine Messstrecke durchquerenden Lichtstrahls und mit einem Lichtempfänger zum Empfangen des ausgesendeten Lichtstrahls am Ende der Messstrecke.

Die Erfindung betrifft weiterhin die Verwendung zumindest eines aufgeheizten, typischerweise nichtstrahlungsfesten Halbleiterbauelementes sowie ein Verfahren zur Erhöhung der funktionalen Lebensdauer von zumindest einem typischerweise nichtstrahlungsfesten Halbleiterbauelement in einem Bereich mit erhöhter radioaktiver Strahlendisposition.

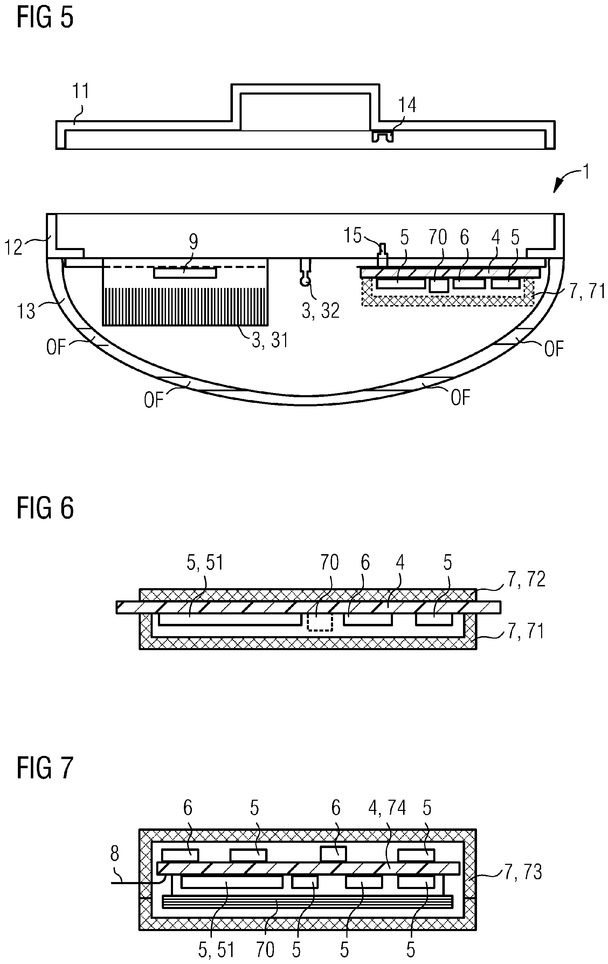

Aus dem US-Patent 5,270,551 sind ein Verfahren und eine Vorrichtung zum Schutz eines elektronischen Schaltkreises gegen Strahlung bekannt, insbesondere in einem künstlichen Satelliten. Die dortige Erfindung geht von der Erkenntnis aus, dass kosmische Strahlung mit einer hohen Dosisrate von 0,1 Gy/h zu einer Ansammlung von eingeschlossenen positiven Ladungsträgern in der dünnen Gateschicht eines FET führt, welche eine Verschiebung der Transistorschwellenspannung in negativer Richtung bewirken. Dagegen führt eine geringe Dosisrate von 0,01 Gy/h zu einer Anzahl von gefangenen Energieniveaus - den sogenannten "trap levels" - in der Zwischenschicht zwischen dem Siliziumlayer und dem Siliziumoxidfilm zu einer Verschiebung der Transistorschwellenspannung in positiver Richtung. Hinzu kommt als weitere Einflussgrösse auf die Transistorschwellenspannung eine mit steigender Temperatur zunehmende Rekombinationsrate, welche der Entstehung von eingeschlossenen positiven Ladungsträgern entgegenwirkt. In der dortigen Figur 5 sind über die Zeit aufgetragene resultierende Gesamtverläufe der Transistorschwellenspannung aufgetragen. Dabei driftet die Transistorschwellenspannung ausgehend von einer Temperatur von 20°C (Kurve 16) und mit dann weiter abnehmender Temperatur (Kurve 17 bis 19) in negativer Richtung. Im Vergleich zu einer Betriebstemperatur von 20°C verbleibt nun die zulässige Verschiebung der Transistorschwellenspannung bei optimaler Kühlung (siehe Kurve 18) noch ca. 3,7 Jahre länger im zulässigen Toleranzband von ± 0,1 V. Es wird ferner vorgeschlagen, die Temperatur eines FET in einem Temperaturbereich von 100 bis 200°C unterhalb der 20°C mit einem Regelbereich von wenigen Grad Celsius bis zu Zehnern Grad Celsius zu regeln.

Bei den Gefahrenmeldern handelt es sich z.B. um Brandmelder, wie z.B. um optische Rauchmelder oder um Hitzemelder. Optische Rauchmelder können z.B. auf dem Streulichtprinzip oder auf dem optoakustischen Prinzip basieren. Ist der Gefahrenmelder ein Hitzemelder, so wird die aktuell in der Umgebung des Hitzemelders vorliegende Temperatur erfasst, wie z.B. mittels eines temperaturabhängigen Widerstands. Die betrachteten Gefahrenmelder können auch Rauchgasmelder sein, welche einen Gassensor als Detektoreinheit aufweisen, wie z.B. einen Gas-FET (FET für Field Effect Transistor). Ferner kann es sich bei den Gefahrenmeldern um Bewegungsmelder handeln, welche zur Bewegungsdetektion eine PIR-Detektoreinheit (PIR für Passive Infrared) aufweisen. Die betrachteten Gefahrenmelder können auch Kombinationen der zuvor genannten Detektoreinheiten aufweisen.

Lineare Rauchmelder basieren auf dem Extinktionsprinzip. Sie werden insbesondere in grossen oder schmalen Räumen, beispielsweise in Korridoren, Lager- und Fabrikationshallen und in Flugzeughangars, eingesetzt und unterhalb der Decke an den Wänden montiert. In einer ersten Ausführungsform liegen Sender und Empfänger einander gegenüber, und es ist kein Reflektor erforderlich. In einer zweiten Ausführungsform wird der vom Sender ausgesandte Lichtstrahl über einen Reflektor zurück zu einem Empfänger umgelenkt. Sender und Empfänger sind benachbart zueinander angeordnet. Die Messtrecke derartiger linearer Rauchmelder liegt typischerweise im Bereich von 20 m bis 200 m, die im Falle der ersten Ausführungsform einer der Messstrecke entsprechenden Distanz zwischen Sender und Empfänger entspricht. Bei der zweiten Ausführungsform entspricht die Distanz zwischen Sender/Empfänger und dem Reflektor der Hälfte der Messstrecke.

Der Bereich mit erhöhter, insbesondere mit hoher radioaktiver Strahlungsdisposition kann z.B. ein Nuklearbereich oder der Weltraum sein. Nuklearbereiche sind insbesondere räumlich abgegrenzte Bereiche zum Beispiel innerhalb eines Kernkraftwerkes, einer kerntechnischen Wiederaufbereitungsanlage oder eines End- oder Zwischenlagers für radioaktiven Abfall gemeint.

Mit radioaktiver Strahlung ist eine ionisierende Teilchen- oder elektromagnetische Strahlung gemeint, die von radioaktiven Stoffen aus geht und welche in der Lage ist, aus Atomen und Molekülen Elektronen loszureissen, so dass positiv geladene Ionen oder Molekülreste zurückbleiben. Während die Alpha- und Betastrahlung als Teilchenstrahlung bereits durch weniger Millimeter dicke Materialdicken abgeschirmt werden kann, ist eine wirksame Abschirmung gegen die elektromagnetische Gammastrahlung nur mit hohem Materialaufwand möglich. Je nach Abschirmungsanforderung können Bleiabschirmungen mit Abschirmdicken von einem Meter und mehr erforderlich sein.

Die radioaktive Strahlung hat im Allgemeinen einen destruktiven Einfluss auf elektronische Bauteile und insbesondere auf Halbleiterbauelemente. Derartige Bauelemente weisen sehr feine Halbleiterstrukturen von weniger als 1 µm, insbesondere von weniger als 100 nm auf. Alle Arten hochenergetischer ionisierender Strahlung treten dabei in Wechselwirkung mit einem Halbleiter-Kristall. Auch wenn eine Abschirmung gegen Alpha- und Betastrahlung vergleichsweise einfach möglich ist, wie z.B. durch ein Gehäuseblech oder eine Kunststoffgehäuse, so hat die Einwirkung der Gammastrahlung auf die Abschirmung oder auf das Gehäuse der Halbleiterbauelemente zur Folge, dass in geringem Umfang auch sekundäre Alpha- und Betateilchen entstehen, die ihrerseits in Wechselwirkung mit dem Halbleiter-Kristall treten. Durch die Wechselwirkung eines solchen eingestrahlten Teilchens mit einem Gitteratom kann dieses aus dem Gitterverband herausgelöst werden, und es entsteht eine Fehlstelle. Das freie Atom kann, wenn es genügend übertragene Stossenergie besitzt, weitere Atome herausschlagen, oder in eine Zwischengitterposition wandern. Es bildet sich ein sogenannter Leerstellen-Zwischengitteratom-Komplex.

Ein wichtiger Einfluss einwirkender Strahlung ist die Erzeugung von Kristalldefekten, die zusätzliche Energiezustände innerhalb des verbotenen Bandes und damit Rekombinationszentren generieren. Diese Effekte treten beschleunigt bei Halbleitermikrostrukturen mit erhöhtem Komplexitätsgrad auf, wie z.B. bei ASICs oder bei Mikrokontrollern. Widerstände oder Kondensatoren sind hingegen aber kaum betroffen.

Aus diesem Grund werden vorzugsweise robuste diskrete Halbleiterbauelemente wie Transistoren oder Dioden eingesetzt, um eine beschleunigte Degenerierung der elektrischen Parameter in der Schaltung zu berücksichtigen, zumal überwiegend strahlungsfeste, ältere integrierte Halbleiterbauteile, wie z.B. ICs, Logikgatter etc., die eine Strukturgrössen von mehr 1 µm aufweisen, aufgrund der weit fortgeschrittenen Miniaturisierung kaum mehr auf dem Halbleitermarkt erhältlich sind.

Durch die Verwendung diskreter Halbleiterbauelement kann somit eine minimale Lebensdauer, wie z.B. von 3 Jahren, entsprechend den einschlägigen Anforderungen, wie z.B. denen bei einem Kernkraftwerk, realisiert werden. Eine solche Anforderung kann z.B. sein, dass ein Brandmelder eine Strahlenbelastung bzw. eine Energiedosis von 0.25 Gy in einem Zeitraum von 3 Jahre "aushalten" muss. Mit Gy (für Gray) ist dabei die SI-Einheit der absorbierten Energiedosis D bezeichnet. Die auf die Zeit bezogene absorbierte Energiedosis wird dabei als Dosisrate bezeichnet.

Eine ausführliche Beschreibung des Einflusses radioaktiver Strahlung auf elektronische Halbleiterbauteile, insbesondere der damit verbundenen zeitlich kumulierten oder zeitlich vorübergehenden Schädigung solcher Halbleiterkomponenten, ist in der Dissertation "Bauelemente-Degradation durch radioaktive Strahlung und deren Konsequenzen für den Entwurf strahlenresistenter elektronischer Schaltungen" von Detlef Brumbi, Fakultät für Elektrotechnik an der Ruhr-Universität Bochum, 1990, beschrieben.

In der Publikation der IEEE Transactions on Nuclear Science, VOL. 37, NO. 6, DECEMBER 1990, mit dem Titel "Modeling the anneal of radiation-induced trapped holes in a varying thermal environment McWhorter", von P. J. McWhorter, S. L. Miller und W. M. Miller vom Sandia National Laboratories, Albuquerque, New Mexico, USA, Dezember 1990, wird ein mathematisches Modell für ein Stressverfahren für MOS-Halbleiter mit hoher Strahlenrate vorgeschlagen, welches präzise Langzeitvorhersagen über die Bildungsrate von induzierten Lochstellen (positive Ladungen) im Halbleitermaterial, insbesondere im als elektrischen Schaltungsisolator eingesetzten Halbleiteroxid, wie z.B. SiO₂, aufgrund der Einwirkung von radioaktiver Strahlung zulässt. Auf Basis dieser ermittelten Bildungsrate sind zuverlässige Aussagen über das Langzeitausfallverhalten des untersuchten Halbleiters bei vergleichsweise kurzer Testzeit bei hoher Strahlungsdisposition möglich.

Die in der Publikation beschriebene Methode zeigt eine Lösung auf, wie die erforderliche Abkühlzeit, das sogenannten "Annealing", reduziert werden kann. Diese Zeit wird für die Rekombination der induzierten Lochstellen nach einer hohen Strahlendisposition benötigt, um letztendlich die Beeinflussung der Strahlendisposition auf die Funktionsfähigkeit des Halbleiters nach dem sogenannten Standard MIL 883 TM 1019 zu ermitteln. In diesem Zusammenhang wird ein der Loch-Bildungsrate entgegengesetzt gerichteter, temperaturabhängiger Rekombinationsprozess beschrieben, dessen Bildungsrate mit zunehmender Halbleitertemperatur gleichfalls zunimmt. Die Ursache für diese Rekombination ist, dass die durch Strahlung erzeugten Ionen im Halbleiteroxid instabil sind und daher bestrebt sind, die fehlenden Elektronen aus ihrer Umgebung zurückzuholen, wodurch die ursprünglichen Moleküle bzw. Atome wiederhergestellt werden.

Ausgehend von dem eingangs genannten Stand der Technik ist es eine Aufgabe der vorliegenden Erfindung, einen verbesserten Gefahrenmelder für den Einsatz im Bereich mit erhöhter radioaktiver Strahlendisposition anzugeben.

Es ist eine weitere Aufgabe der Erfindung, eine vorteilhafte Verwendung von zumindest einem aufgeheizten, typischerweise nichtstrahlungsfesten Halbleiterbauelement anzugeben.

Schliesslich ist es eine Aufgabe der vorliegenden Erfindung, ein Verfahren zur Erhöhung der funktionalen Lebensdauer von zumindest einem typischerweise nichtstrahlungsfesten Halbleiterbauelement, insbesondere im Bereich mit erhöhter radioaktiver Strahlendisposition anzugeben.

Diese Aufgaben werden durch die Gegenstände der unabhängigen Patentansprüche gelöst. Vorteilhafte Ausführungsformen der vorliegenden Erfindung sind in den abhängigen Ansprüchen beschrieben.

Erfindungsgemäss weist der Gefahrenmelder einen Temperaturregelkreis auf. Der Temperaturregelkreis ist dazu eingerichtet, die Temperatur des zumindest einen Halbleiterbauelementes zu regeln.

Dadurch wird vorteilhaft unabhängig von der Anbringung des Gefahrenmelders eine gleiche Halbleitertemperatur erreicht.

Grundgedanke der Erfindung ist, dass durch die Regelung des zumindest einen Halbleiterbauelementes, insbesondere eines typischerweise nichtstrahlungsfesten Halbleiterbauelementes, auf eine vorgegebene Betriebstemperatur die im Halbleitermaterial, insbesondere im Halbleiterisolatormaterial wie Siliziumdioxid oder Siliziumnitrid, durch die radioaktive Strahlendisposition induzierte erhöhte elektrische Löcher-Leitfähigkeit nun durch eine mit zunehmender Betriebstemperatur erhöhte Löcher-Rekombinationsrate zumindest teilweise kompensiert wird. Dadurch bleibt die für das ordnungsgemässe Funktionieren einer elektronischen Schaltung massgebliche Schaltschwellenspannung vorteilhaft länger, insbesondere für eine geforderte Mindestbetriebszeit, wie z.B. von drei Jahren, innerhalb des vorgegebenen zulässigen Toleranzbandes.

Mit "nichtstrahlungsfesten Halbleiterbauelementen" sind hier Halbleiterbauelemente gemeint, die nicht für den Einsatz im Nuklearbereich vorgesehen sind. Diese sind typischerweise für den Consumermarkt oder für militärische Anwendungen bestimmte Halbleiterkomponenten. Besonderes Merkmal ist, dass die zuvor genannten Halbleiterbauelemente bei einer Strahlenbelastung bzw. bei einer Energiedosis von 0.25 Gy bereits innerhalb von wenigen Monaten ausfallen bzw. erst gar nicht funktionieren.

Nach einer Ausführungsform weist der Temperaturregelkreis ein insbesondere elektrisches Heizelement zum geregelten Beheizen des zumindest einen Halbleiterbauelementes aufweist. Dadurch ist für den Fall, dass die elektrische Wärmeverlustleistung der nichtstrahlungsfesten Halbleiterbauelemente und gegebenenfalls der weiteren elektrischen Bauelemente nicht ausreicht, den vorgegebenen Bereich der Betriebstemperatur einzuhalten, vorteilhaft ein Aufheizen und ein Verbleib im geforderten Temperaturbereich möglich. Das elektrische Heizelement ist vorzugsweise ein ohmscher Widerstand. Es kann z.B. als Flächenheizelement realisiert sein.

Nach einer besonderen Ausführungsform ist das zumindest eine Halbleiterbauelement ein prozessorgestützter Mikrocontroller oder Prozessor. Es ist zumindest ein Computerprogramm auf dem Mikrocontroller ausführbar, das geeignet ist, die elektrische Verlustleistung des Mikrocontrollers und/oder zumindest eines durch den Mikrocontroller ansteuerbaren weiteren Halbleiterbauelementes in Abhängigkeit der erfassten Temperatur des Halbleiterbauelementes im Sinne einer Heizung zu steuern.

Dadurch vereinfacht sich der Aufwand für eine Heizung. Vielmehr kann auf ein separates Heizelement verzichtet werden. Die Erhöhung der Verlustleistung im Mikrocontroller selbst kann z.B. durch Speicherkopieraktionen oder durch Ausführungen von mathematischen Funktionen im Sinne einer Steigerung der CPU- oder Prozessorauslastung gesteigert werden. Alternativ kann bei einem Kühlbedarf der normale Programmablauf auf einen minimalen Funktionsbetrieb umgestellt werden, wobei lediglich die für den Gefahrenmeldebetrieb unbedingt notwendigen Programmschritte ausgeführt werden.

Es kann auch zumindest ein Teil des Temperaturregelkreises als ein auf dem Mikrocontroller ausführbares Computerprogramm realisiert sein.

Dadurch vereinfacht sich weiterhin der technische Aufwand für einen Temperaturregelkreis erheblich. Typischweise umfasst ein solcher Temperaturregelkreis eine Temperaturerfassung für einen Temperaturistwert, einen Vergleicher zum Vergleich des erfassten Temperaturistwertes mit einem vorgegebenen Temperatursollwert, einen Regler, welchem der ermittelte Vergleichswert als Fehlerabweichung zugeführt wird, und schliesslich ein nachfolgendes Stellglied zum Ansteuern des elektrischen Heizelementes. Der vorgegebene Temperatursollwert kann z.B. elektronisch in einem nichtflüchtigen Speicher des Mikrocontrollers hinterlegt sein.

Vorzugsweise ist der gesamte Temperaturregelkreis im Mikrocontroller integriert, wobei dann der Temperatursensor gleichfalls im Mikrocontroller integriert ist. Es kann auch nur ein Teil des Temperaturregelkreises im Mikrocontroller integriert sein, wie z.B. nur der Regler oder das Stellglied. Auch kann das den Temperaturregelkreis realisierende Temperaturregelprogramm und das Computerprogramm für die Steuerung der Verlustleistung ein gemeinsames Computerprogramm sein. Das zumindest weitere Halbleiterbauelement kann z.B. ein elektronischer Schalter sein, wie z.B. ein Transistor, welcher "sowieso" vorhanden ist und durch geeignete Ansteuerung, wie z.B. durch eine hochfrequente Ansteuerung, sich besonders erhitzt, ohne seine eigentliche Schaltfunktion in Hinblick auf die nachfolgenden Schaltungsteile zu beeinflussen.

Der Mikrocontroller kann z.B. einen Temperatureingang aufweisen, einen Eingang zum Anschliessen eines Temperatursensors, wie z.B. eines NTCs, oder einen bereits integrierten Temperatursensor zur Erfassung der Umgebungstemperatur aufweisen. Der Mikrocontroller ist weiterhin zur Ansteuerung eines Schaltelementes, wie z.B. eines Transistors, eingerichtet oder er weist bereits einen Schaltausgang auf, so dass das elektrische Heizelement angesteuert werden kann. Weiterhin kann auf dem Mikrocontroller ein Temperaturregelungsprogramm gespeichert sein, so dass über die Erfassung der Umgebungstemperatur als Istwert auf den vorgegebenen Betriebstemperaturbereich geregelt werden kann. Vorzugsweise wird auf eine Betriebstemperatur mit einer Abweichung von wenigen Grad Celsius geregelt.

Vorzugsweise ist der Temperaturregelkreis zur Regelung auf eine vorgegebene, vorzugsweise annähernd konstante Betriebstemperatur in einem Bereich von 60°C bis 160°C, insbesondere von 80°C bis 125°C, eingerichtet. Das Verbleiben der Halbleiterbauelemente im oben genannten Betriebstemperaturbereich kann z.B. durch eine thermische Isolierung der Halbleiterbauelemente erfolgen, die derart ausgelegt ist, dass die eigene Verlustwärme der Halbleiterbauelemente zum Aufheizen und Verbleiben in dem Temperaturbereich ausreichend ist. Der Betriebstemperaturbereich kann zudem auch enger gefasst sein, wie z.B. in einem Bereich von 90°C bis 110°C, von 80°C bis 100°C oder von 70°C bis 90°C.

Der Betriebstemperaturbereich kann insbesondere messtechnisch oder empirisch ermittelt werden, so dass eine vorgegebene, vom verwendeten Halbleiterwerkstoff und von der eingesetzten Schaltungslogik abhängige, maximal zulässige Abweichung der Schaltspannungsschwelle, dass heisst der sog. Threshold-Spannung, von einer Raumtemperatur-Schaltspannungsschwelle als Nennschaltspannungsschwelle nicht überschritten wird.

Nach einer Ausführungsform ist das zumindest eine Halbleiterbauelemente von der Detektoreinheit entkoppelt. Mit "thermischer Entkopplung" ist gemeint, dass kein nennenswerter und im Prinzip vernachlässigbarer Wärmeeintrag von den aufgeheizten Halbleiterbauelementen hin zur Detektoreinheit erfolgt.

Dadurch wird vorteilhaft der Raucheintritt in das Meldergehäuse, insbesondere bei einem Rauchmelder, nicht durch Thermikeffekte nachteilig beeinträchtigt. Anderenfalls könnte die auf die Detektoreinheit übergreifende Wärme den Raucheintritt erschweren oder derart ablenken, dass im Brandfall keine ausreichende Anzahl von zu detektierenden Rauchteilchen in das Innere der Detektoreinheit gelangen kann. Letztere ist vorzugsweise eine optische Messkammer nach dem Streulichtprinzip oder ein sogenanntes Labyrinth mit einer Vielzahl von gegen Aussenlicht abgeschirmten Raucheintrittsöffnungen. Die thermische Entkopplung kann z.B. durch ein Wärmeleitblech oder durch eine Anordnung der Halbleiterbauelemente oberhalb der Detektoreinheit erreicht werden, wobei im letzteren Fall vorzugsweise die Halbleiterbauelemente zur Einleitung der Abwärme wärmeleitend z.B. mit der Decke als Montagefläche verbunden sind.

Vorzugsweise ist die Detektoreinheit räumlich getrennt von dem zumindest einen Halbleiterbauelement angeordnet. In vielen Fällen reicht bereits eine räumliche Trennung von wenigen Zentimetern aus, wobei hier die Umgebungsluft als thermischer Isolator fungiert. Vorzugsweise erstreckt sich die räumliche Trennung in vertikaler Richtung, wobei die aufgeheizten Halbleiterbauelemente oberhalb der Detektoreinheit angeordnet sind, sodass die Abwärme der Thermik folgend nach oben abgeführt werden kann bzw. entweichen kann.

Einer weiteren Ausführung zufolge ist die Detektoreinheit dazu eingerichtet, eine physikalische Eigenschaft, wie z.B. die Temperatur, die Rauchdichte etc., der angrenzenden Umgebungsluft erfassen. Die Detektoreinheit ist hierbei vom zumindest einen Halbleiterbauelement thermisch entkoppelt, wie z.B. durch eine Wärmeisolierschott, eine Trennwand oder ein Luftleitblech.

Nach einer bevorzugten Ausführungsform weist der Gefahrenmelder eine Wärmeisolierung für das zumindest eine Halbleiterbauelement auf. Dadurch wird einerseits vorteilhaft eine besonders effektive thermische Entkopplung zur Detektoreinheit erreicht. Andererseits können die Kennwerte der Wärmeisolierung so bestimmt werden, wie z.B. die Dicke, die Abmessungen und der Wärmeleitkoeffizient eines Dämmstoffes, dass die über die Oberfläche der Wärmedämmung abgegebene Wärme und die eigene Verlustwärme der thermisch isolierten Halbleiterbauelemente so im thermischen Gleichgewicht sind, dass die Halbleiterbauelemente und gegebenenfalls die weiteren elektrischen Bauelemente vorteilhaft im vorgegebenen Bereich der Betriebstemperatur verbleiben.

Die Wärmeisolierung kann z.B. als Kapsel aus Dämmstoff realisiert sein, in welcher die nichtstrahlungsfesten Halbleiterbauelemente sowie gegebenenfalls die weiteren, typischerweise strahlungsfesten elektrischen Bauelemente aufgenommen sind. Letztere sind z.B. passive Bauelemente wie Widerstände, Spulen oder Kondensatoren oder elektronische Bauteile wie Halbleiterdioden oder Transistoren mit Halbleiterstruktur im µm-Bereich.

Die Wärmeisolierung kann auch als Halbschale aus Dämmstoff realisiert sein, welche die typischerweise auf einem Schaltungsträger angeordneten nichtstrahlungsfesten Halbleiterbauelemente sowie gegebenenfalls die weiteren elektrischen Bauelemente von einer jeweiligen Bestückungsseite her umschliesst.

Weiterhin kann die Wärmeisolierung auch als elastische Platte oder als Schaum realisiert sein, welche die nichtstrahlungsfesten Halbleiterbauelemente sowie gegebenenfalls die weiteren elektrischen Bauelemente im Sinne einer Passivierung abdeckt.

Als Dämmstoffe kommen für den vorgesehenen Betriebstemperaturbereich temperaturbeständige Kunststoffe wie z.B. Polyurethan in Form von Hartschaumplatten in Frage. Sie können auch geschäumte Elastomere sein, die auf Neopren-Kautschuk, auf EPDM (für Ethylen-Propylen-Dien-Kautschuk) oder ähnlichen gummiartigen Basismaterialien basieren. Sie können weiterhin z.B. aus geschäumtem Glas bestehen.

Alternativ oder zusätzlich kann die Wärmeisolierung eine Vakuumisolierung nach dem Thermoskannenprinzip sein. In diesem Fall können die nichtstrahlungsfesten Halbleiterbauelemente sowie gegebenenfalls die weiteren elektrischen Bauelemente in einer weitgehend luftentleerten Kapsel, wie z.B. aus Metall, aufgenommen sein. Die Kapsel kann auch doppelwandig ausgeführt sein, wobei dann der Bereich zwischen der Doppelwand weitgehend luftentleert bzw. mit einem wärmedämmenden Gas, wie z.B. Edelgas, gefüllt ist. Die elektrischen Zuleitungen sind dann entsprechend gasdicht aus dieser Kapsel herausgeführt.

Einer weiteren Ausführungsform zufolge weist der Gefahrenmelder ein derart ausgestaltetes Gehäuse auf, dass die im Nuklearbereich auf den Gefahrenmelder auftreffende radioaktive Teilchenstrahlung im Wesentlichen abgeschirmt wird. Bei der im Nuklearbereich verbleibenden Teilchenstrahlung handelt es sich im Wesentlichen noch um Gammastrahlung und im geringen Masse um Neutronenstrahlung. Das Gehäuse kann z.B. aus einem mehreren Millimeter dicken Kunststoffgehäuse oder aus einem Metallgehäuse, wie z.B. aus Aluminium, gefertigt sein. Die Dicke liegt vorzugsweise im Bereich von 4 bis 10 mm.

Das zumindest eine aufgeheizte, typischerweise nichtstrahlungsfeste Halbleiterbauelement kann gemäss der Erfindung vorteilhaft in einem Bereich mit erhöhter, insbesondere mit intensiver radioaktiver Strahlendisposition verwendet werden. Hierzu wird das zumindest eine Halbleiterbauelement auf eine Betriebstemperatur im Bereich von 60°C bis 160°C, insbesondere im Bereich von 80°C bis 125°C, regelt. Dadurch wird eine im Halbleitermaterial durch die radioaktive Strahlendisposition induzierte erhöhte elektrische Löcher-Leitfähigkeit durch eine mit zunehmender Betriebstemperatur erhöhte Löcher-Rekombinationsrate zumindest teilweise kompensiert.

Die Aufgabe der Erfindung wird weiterhin mit einem als linearer Rauchmelder ausgebildeten erfindungsgemässen Gefahrenmelder gelöst. Ein solcher linearer Rauchmelder weist eine Rauchmeldereinheit mit zumindest einer Lichtumlenkeinheit auf. Die Rauchmeldereinheit umfasst die Detektoreinheit mit einem Lichtsender zur Aussendung eines eine Messstrecke durchquerenden Lichtstrahls und einen Lichtempfänger zum Empfangen des ausgesendeten Lichtstrahls am Ende der Messstrecke, um die zumindest eine Gefahrenkenngrösse zu detektieren. Die zumindest eine Umlenkeinheit ist zur Umlenkung des vom Lichtsender ausgesandten Lichtstrahls zurück auf den Lichtempfänger vorgesehen. Die Rauchmeldereinheit weist weiterhin das zumindest eine Halbleiterbauelement und die weiteren elektrischen Bauelemente zumindest zur Ausgabe des Meldersignals auf.

Die Aufgabe der Erfindung wird weiterhin mit einem Verfahren zur Erhöhung der funktionalen Lebensdauer von zumindest einem, typischerweise nichtstrahlungsfesten Halbleiterbauelement in einem Bereich mit erhöhter radioaktiver Strahlendisposition gelöst, wobei das zumindest eine Halbleiterbauelement hierzu auf eine Betriebstemperatur im Bereich von 60°C bis 160°C, insbesondere im Bereich von 80°C bis 125°C geregelt wird. Dadurch wird wiederum die im Halbleitermaterial durch die radioaktive Strahlendisposition induzierte erhöhte elektrische Löcher-Leitfähigkeit durch eine mit zunehmender Betriebstemperatur erhöhte Löcher-Rekombinationsrate zumindest teilweise kompensiert. Dadurch kann die funktionale Lebensdauer der Halbleiterbauelemente im Vergleich zu Halbleiterbauelemente bei Raumtemperatur deutlich erhöht, insbesondere um ein Mehrfaches gesteigert werden.

Nach einer Verfahrensvariante sind die aufgeheizten Halbleiterbauelemente zusammen mit weiteren elektrischen Bauelementen zum Betrieb von elektrischen Geräten vorgesehen. Diese Geräte können z.B. Steuereinrichtungen, Steuergeräte oder auch die betrachteten Gefahrenmelder umfassen.

Die Erfindung sowie vorteilhafte Ausführungen der vorliegenden Erfindung werden am Beispiel der nachfolgenden Figuren erläutert. Dabei zeigen:
- FIG 1: ein Beispiel für eine Gefahrenmeldeanlage mit einer Meldezentrale und mit drei, jeweils über eine Zweidrahtleitung an der Meldezentrale angeschlossene Gefahrenmelder in einem Nuklearbereich,
- FIG 2: ein Beispiel für eine weitere Gefahrenmeldeanlage mit einer Meldezentrale und mit drei über eine gemeinsame Zweidrahtleitung an der Meldezentrale angeschlossene, adressierbare Gefahrenmelder in einem Nuklearbereich,
- FIG 3: ein Beispiel für einen Temperaturregelkreis zur Regelung der Temperatur eines Halbleiterbauelementes,
- FIG 4: ein Beispiel für einen in einem Mikrocontroller integrierten Temperaturregelkreis sowie zur möglichen Steuerung der eigenen elektrischen Verlustleistung,
- FIG 5: einen beispielhaften Aufbau eines erfindungsgemässen Gefahrenmelders am Beispiel eines kombinierten Rauchgas-/Hitzemelders nach einer ersten Ausführungsform,
- FIG 6: ein erstes Beispiel für eine Wärmeisolierung von nichtstrahlungsfesten Halbleiterbauelementen gemäss der Erfindung,
- FIG 7: ein zweites Beispiel für eine Wärmeisolierung von nichtstrahlungsfesten Halbleiterbauelementen gemäss der Erfindung,
- FIG 8: einen beispielhaften Aufbau eines erfindungsgemässen Gefahrenmelders am Beispiel eines Brandmelders nach einer zweiten Ausführungsform,
- FIG 9: einen beispielhaften Aufbau eines erfindungsgemässen Gefahrenmelders am Beispiel eines Brandmelders nach einer dritten Ausführungsform, und
- FIG 10: ein Beispiel für einen als linearen Rauchmelder ausgebildeten Gefahrenmelder gemäss der Erfindung mit einer Umlenkeinheit und einer Rauchmeldereinheit.

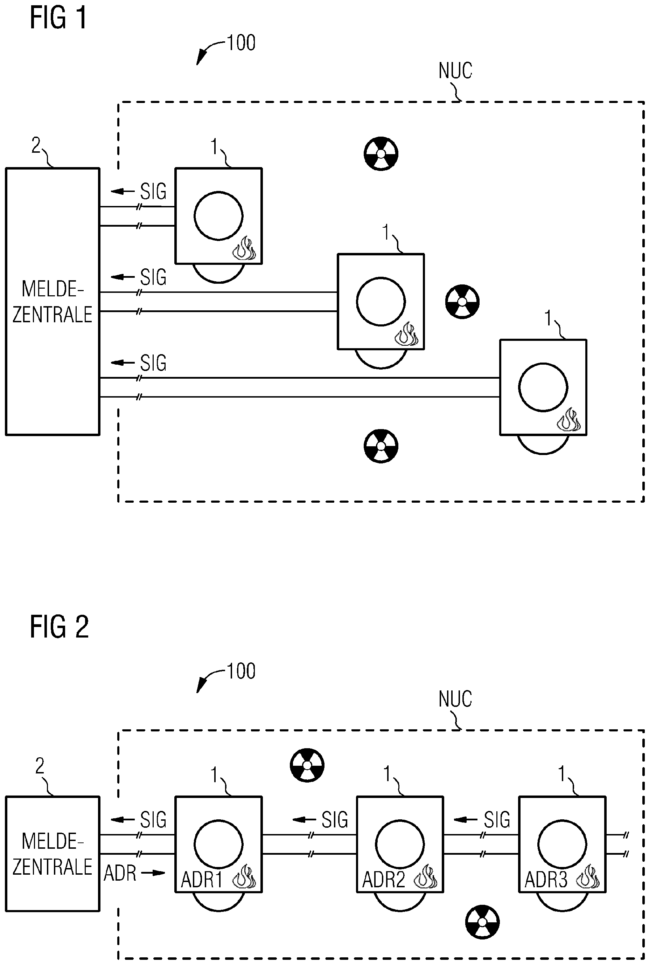

FIG 1 zeigt ein Beispiel für eine Gefahrenmeldeanlage 100 mit einer Meldezentrale 2 und mit drei, jeweils über eine an sich bekannte Zweidrahtleitung an der Meldezentrale 2 angeschlossene Gefahrenmelder 1 in einem Nuklearbereich NUC.

Der Nuklearbereich NUC ist durch drei Symbole für radioaktive Strahlung gekennzeichnet. Die gezeigten Gefahrenmelder 1 können z.B. optische Rauchmelder sein, welche eine optische Detektoreinheit nach dem Streuprinzip zur Detektion von Rauchpartikeln aufweisen. Er kann alternativ als Hitzemelder eine Temperatur-Detektoreinheit, wie z.B. einen Temperatursensor, zur Branddetektion aufweisen. Weiterhin kann er als Rauchgasmelder einen Gassensor zur Detektion brandtypischer Rauchgase aufweisen. Da die Gefahrenmelder 1 punktförmig in einem zu überwachenden Bereich verteilt angeordnet sind, können diese auch als Punkmelder bezeichnet werden.

Weiterhin ist die Meldezentrale 2 ausserhalb des Nuklearbereichs NUC angeordnet. Sie kann für den Fall, dass zumindest überwiegend nur Brandmelder 1 und insbesondere nur Rauchmelder 1 angeschlossen sind, auch als Brandmeldezentrale bezeichnet werden. Da die Meldezentrale 2 grundsätzlich nicht zum Betrieb in einem Nuklearbereich NUC vorgesehen ist, weist diese typischerweise nur industriegeeignete Halbleiterbauelemente auf. Mit ST ist ein jeweils vom angeschlossenen Gefahrenmelder 1 ausgegebener Detektorstatus ST bezeichnet. Der Detektorstatus ST kann z.B. ein erster oder zweiter Alarmlevel, eine Betriebsbereitmeldung oder eine Fehlermeldung sein. Üblicherweise werden die möglichen Zustände eines solchen Detektorstatus ST in bekannter Weise strommoduliert vom angeschlossenen Gefahrenmelder 1 an die Meldezentrale 2 übertragen. Der jeweilige Detektorstatus ST wird letztlich durch die Meldezentrale 2 erfasst, die dann gegebenenfalls eine Alarmmeldung ausgibt, wie z.B. an eine Feuerwehr.

FIG 2 zeigt ein Beispiel für eine weitere Gefahrenmeldeanlage 100 mit einer Meldezentrale 2 und mit drei über eine gemeinsame Zweidrahtleitung an der Meldezentrale 2 angeschlossene, adressierbare Gefahrenmelder 1 in einem Nuklearbereich NUC.

Mit ADR1-ADR3 ist eine jeweilige Auswahladresse bezeichnet, die in den gezeigten Gefahrenmeldern 1 vorzugsweise manuell eingestellt worden ist. Mit ADR ist eine von der Meldezentrale 2 ausgegebene Melderadresse bezeichnet. Stimmt diese mit einer der Auswahladressen ADR1-ADR3 überein, so ist der jeweilige Gefahrenmelder 1 adressiert. Mit ST ist wiederum der vom adressierten Gefahrenmelder 1 ausgegebene Detektorstatus als Reaktion auf die erfolgte gültige Adressierung bezeichnet.

Vorzugsweise erfolgt die Stromversorgung der Gefahrenmelder 1 sowohl in FIG 1 als auch in FIG 2 über die nicht weiter bezeichneten Zweidrahtleitungen durch die Meldezentrale 2. Die Zweidrahtleitung kann auch als Melderbus bezeichnet werden.

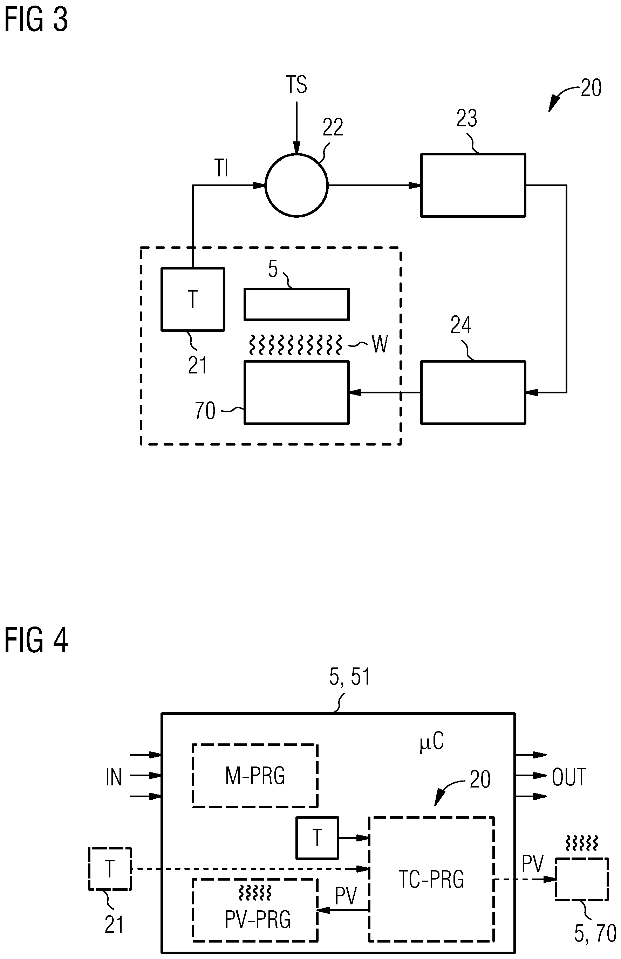

FIG 3 zeigt ein Beispiel für einen Temperaturregelkreis 20 zur Regelung der Temperatur eines Halbleiterbauelementes 5. Der Temperaturregelkreis 20 weist hier einen Temperatursensor 21 zur Erfassung eines Temperaturistwerts TI, einen Vergleicher 22 bzw. Differenzbildner zum Vergleich des erfassten Temperaturistwertes TI mit einem vorgegebenen Temperatursollwert TS, einen Regler 23, welchem der ermittelte Vergleichswert als Fehlerabweichung zugeführt wird, und schliesslich ein nachfolgendes Stellglied 24 zum Ansteuern des elektrischen Heizelementes 70 auf. Der Temperatursensor 21 ist dabei benachbart zum Heizelement 70 angeordnet, um möglichst schnell und unverfälscht die aktuelle Temperatur im Bereich des Halbleiterbauelementes 5 zu erfassen. Mit dem Bezugszeichen W sind die Wärmestrahlen symbolisiert, welche das Aufheizen des darüberliegenden Halbleiterbauelementes 5 bewirken.

FIG 4 zeigt ein Beispiel für einen in einem Mikrocontroller 51 integrierten Temperaturregelkreis 20 sowie zur möglichen Steuerung der eigenen elektrischen Verlustleistung. Mit IN, OUT sind an sich bekannte Signal- ein und -ausgänge eines Mikrocontrollers 20 bezeichnet. Erfindungsgemäss ist zumindest ein Teil des Temperaturregelkreises 20 als ein auf dem Mikrocontroller 51 ausführbares Computerprogramm TC-PRG realisiert. Es ist zudem ein weiteres Computerprogramm PV-PRG auf dem Mikrocontroller 51 ausführbar, welches geeignet ist, die elektrische Verlustleistung des Mikrocontrollers 51 in Abhängigkeit der erfassten Temperatur des Halbleiterbauelementes 5, 51 im Sinne einer Heizung 70 zu steuern. Mit PV ist eine vom Temperaturregelkreis 20 ermittelter Sollwert für die Verlustleistung bezeichnet. Mit M-PRG ist weiterhin ein Steuerprogramm zur Ausführung der Funktion des Gefahrenmelders bezeichnet. Dieses kann z.B. die Erfassung, Auswertung und die Generierung einer Gefahrenmeldung bewirken.

Wie in der FIG 4 gestrichelt angedeutet, können auch der Teile des Temperaturregelkreises 20 ausserhalb des Mikrocontrollers 51 angeordnet sein, wie hier ein externer Temperatursensor 21. Es kann alternativ oder zusätzlich ein weiteres, durch den Mikrocontroller 52 ansteuerbares Halbleiterbauelement 5 vorhanden sein, um bedarfsweise eine höhere elektrische Heizleistung bereitzustellen.

FIG 5 zeigt einen beispielhaften Aufbau eines erfindungsgemässen Gefahrenmelders 1 am Beispiel eines kombinierten Rauchgas-/Hitzemelders nach einer ersten Ausführungsform.

Im oberen Teil der gezeigten Figur ist ein Meldersockel 11 zu sehen, auf dem der eigentliche Gefahrenmelder 1 lösbar befestigt werden kann. Der Meldersockel 11 ist typischerweise zur vereinfachten Montage der Gefahrenmelder 1 vorgesehen. Dieser wird üblicherweise beabstandet zu weiteren Meldersockeln 11 an der Decke eines zu überwachenden Bereichs montiert. Zugleich dient der Meldersockel 11 zum Anschluss an einen linienförmig oder sternförmig verlegten Melderbus oder zum Anschluss an eine entsprechende Zweidrahtleitung, wie in FIG 1 und FIG 2 gezeigt. Der linienförmige Melderbus wird dabei von einem Meldersockel 11 zum nächsten Meldersockel 11 durchgeschleift, wobei die jeweiligen Leitungen der Zweidrahtleitung elektrisch kontaktiert und zu einem zugehörigen Melderkontakt 14, wie z.B. in Form einer Buchse, weitergeführt werden. Der Melderkontakt 14 ist zum Kontaktieren mit einem entsprechenden Gegenkontakt 15, wie z.B. in Form eines Steckerkontakts, im befestigten Zustand des Gefahrenmelder 1 auf dem Meldersockel 11 vorgesehen. Natürlich kann der Meldersockel 11 auch integraler Bestandteil des Gefahrenmelders 1 selbst sein.

Im unteren Teil der FIG 5 ist eine Schnittdarstellung durch einen erfindungsgemässen Gefahrenmelder 1 zu sehen. Mit dem Bezugszeichen 12 ist ein Grundkörper und mit 13 eine Abdeckung des Meldergehäuses 12, 13 zu sehen. In der Abdeckung 13 sind zudem Öffnungen OF vorhanden, durch welche zu detektierenden Rauch, zu detektierende Rauchgase und/oder zu detektierende erhitzte Luft in eine entsprechende, innenliegende Detektoreinheit 3 gelangen kann.

Im vorliegenden Beispiel handelt es sich um einen kombinierten Rauchgas-/Hitzemelder 1 mit einer Rauchgas-Detektoreinheit 31 und einer Temperatur-Detektoreinheit 32 in Form eines temperaturabhängigen Widerstands. Mit dem Bezugszeichen 9 ist ein für spezifische Brandgase sensitiver Gassensor, wie z.B. Gas-FET, bezeichnet. Die entsprechenden Detektorsignale werden dann üblicherweise durch eine elektronische Auswerteeinheit, wie z.B. durch einen Mikrocontroller, ausgewertet. Letztere generiert darauf basierend einen zugeordneten Detektorstatus, der letztendlich auf dem Melderbus ausgegeben wird, wie z.B. eine Alarmmeldung.

Gemäss der Erfindung ist der gezeigte Gefahrenmelder 1 nun dazu eingerichtet, dass die typischerweise nichtstrahlungsfesten Halbleiterbauelemente 5 sowie gegebenenfalls weitere, an sich strahlungsfeste elektrische Bauelemente 6 in einem Betriebstemperaturbereich von 60°C bis 160°C, insbesondere von 80°C bis 125°C, verbleiben. Die zuvor genannten Bauelemente 5, 6 sind dabei auf einem Schaltungsträger 4 angeordnet, wie z.B. auf einer Leiterplatte. Zudem sind die gezeigten Bauelemente 5, 6 thermisch von den beiden Detektoreinheiten 3 thermisch entkoppelt. Dies wird im vorliegenden Beispiel durch die räumliche Trennung voneinander erreicht. Zusätzlich kann auch eine im Grundgehäuse 12 oder in der Abdeckung 13 ausgebildete oder angeordnete, nicht weiter gezeigte Trennwand vorhanden sein, welche die beiden Detektoreinheiten 3 von der Leiterplatte 4 mit den Bauelementen 5, 6 thermisch abtrennt.

Im vorliegenden Beispiel sind die Bauelemente 5, 6 durch eine haubenförmige Wärmeisolierhalbschale 71 gegenüber der Umgebung wärmeisoliert. Dadurch reduziert sich der erforderliche Raum zum Aufheizen der nichtstrahlungsfesten Halbleiterbauelemente 5 auf das abgeschlossene Innere der Wärmeisolierhalbschale 71. Dadurch wird eine noch verbleibende, aber mögliche thermische Beeinflussung der beiden Detektoreinheiten 31, 32 verhindert. Mit dem Bezugszeichen 70 ist weiterhin ein Heizelement in Form eines ohmschen Widerstands bezeichnet, der zum Beheizen der Bauelemente 5, 6 auf der Leiterplatte 4 vorgesehen sein kann. Dies für den Fall, dass die eigene elektrische Wärmeverlustleistung der Bauelemente 5, 6 trotz der Wärmeisolierung 7 nicht ausreichen sollte. Dies kann z.B. dann der Fall sein, wenn der geforderte Betriebstemperaturbereich im Vergleich zur Umgebungstemperatur deutlich darüber liegt, wie z.B. um mehr als 30°C. In diesem Fall wird der über den Melderbus zum Heizen erforderliche Strombedarf vorteilhaft durch die Wärmeisolierung 7 minimiert.

FIG 6 zeigt ein erstes Beispiel für eine Wärmeisolierung 7 von nichtstrahlungsfesten Halbleiterbauelementen 5 gemäss der Erfindung. In diesem Fall setzt sich die Wärmeisolierung 7 aus einer Wärmeisolierhalbschale 71 und einer gegenüberliegenden, lediglich durch den Schaltungsträger 4 getrennten Wärmeisolierplatte 72 zusammen. Dadurch wird der Grad der Wärmeisolierung gegenüber der Umgebung im Vergleich zur vorherigen Ausführung gesteigert.

FIG 7 zeigt ein zweites Beispiel für eine Wärmeisolierung 7 von nichtstrahlungsfesten Halbleiterbauelementen 5 gemäss der Erfindung. Im vorliegenden Beispiel sind beide Seiten des Schaltungsträgers 4 sowohl mit nichtstrahlungsfesten Halbleiterbauelementen 5 und weiteren elektrischen Bauelementen 6 bestückt. In diesem Fall ist die Wärmeisolierung 7 als Kapsel 73 ausgeführt, in welcher der komplette Schaltungsträger 4 samt der Bauteile 5, 6 aufgenommen ist. Mit dem Bezugszeichen 8 ist ein elektrischer Anschluss bezeichnet, der aus der Wärmeisolierkapsel 73 zur Stromversorgung, zur Signalerfassung und zur Signalausgabe herausgeführt ist. Die gezeigte Kapsel 73, kann wie zeichnerisch angedeutet zur vereinfachten Montage auch zweiteilig ausgeführt sein. Im Vergleich zur vorherigen Ausführungsform wird der Grad der Wärmeisolierung gegenüber der Umgebung nochmals gesteigert.

Darüber hinaus ist auf dem Schaltungsträger 4 ein Flächenheizelement 70 zu sehen, welches elektrisch über nicht weiter bezeichnete Zuführungskontakte zum Schaltungsträger 4 gespeist wird. Durch die flächige Ausführung des Heizelementes 70 ist eine gleichmässige Beheizung der Bauelemente 5, 6 möglich. Desweiteren weist der gezeigte Gefahrenmelder 1 eine Temperaturregelung auf, sodass insbesondere die nichtstrahlungsfesten Halbleiterbauelemente 5 mittels des Heizelementes 70 in dem Betriebstemperaturbereich verbleiben. Im vorliegenden Fall wird diese durch einen Mikrocontroller 51 realisiert, der zugleich auch ein nichtstrahlungsfestes Halbleiterbauelement 5 ist. Die Erfassung der Ist-Temperatur kann z.B. durch einen im Mikrocontroller 51 bereits integrierten Temperatursensor erfolgen. Die elektrische, vorzugsweise getaktete Ansteuerung eines nicht weiter gezeigten elektronischen Halbleiterschalters für die Stromzufuhr für das Heizelement 70 erfolgt gleichfalls durch den Mikrocontroller 51 auf Basis eines dort gespeicherten ausführbaren Temperaturregelungscomputerprogramms.

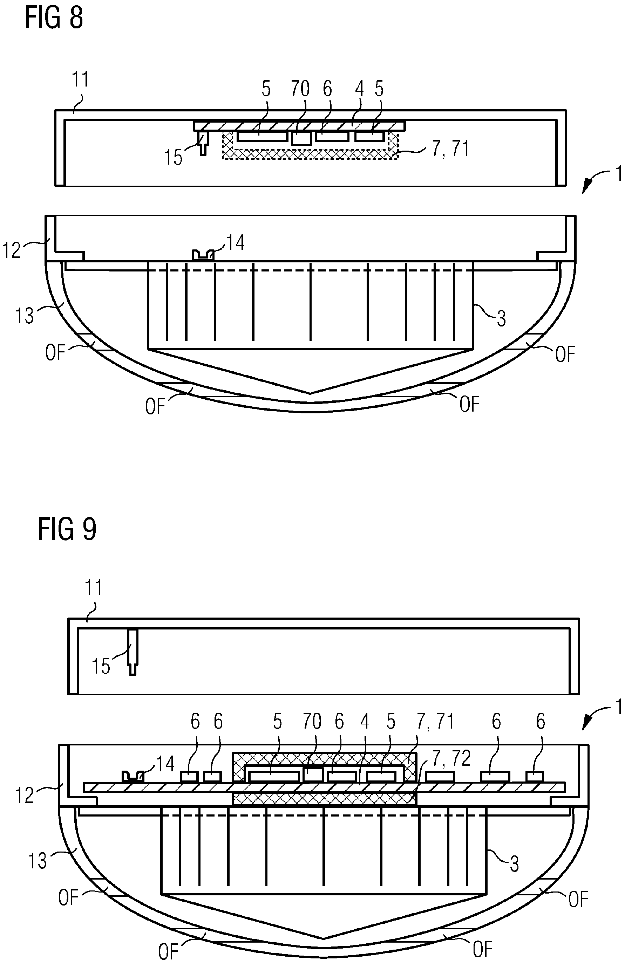

FIG 8 zeigt einen beispielhaften Aufbau eines erfindungsgemässen Gefahrenmelders 1 am Beispiel eines Brandmelders nach einer zweiten Ausführungsform. Im Gegensatz zur Ausführungsform gemäss FIG 7 erfolgt hier die Anordnung der gesamten wärmeisolierten, aufgeheizten "Elektronik" bzw. Steuereinheit des Brandmelders 1, das heisst des Schaltungsträgers 4, der Bauelemente 5, 6, des Heizelementes 70 und der Wärmeisolierhalbschale 71, im Meldersockel 11. Der elektrische Verbindung zur Stromversorgung, zur Ansteuerung sowie zur Signalerfassung der nicht weiter gezeigten optoelektronischen Bauelemente in der Rauchmelder-Detektoreinheit 3 erfolgt im montierten Zustand des Brandmelders 1 auf dem Meldersockel 11 wiederum über die elektrischen Kontakte 14, 15. Im vorliegenden Beispiel erfolgt die thermische Entkopplung des Schaltungsträgers 4 mit den Bauelementen 5, 6, 70 zu der Detektoreinheit 3 durch die räumlich vertikal getrennte Anordnung voneinander. Die gestrichelte Umrandung der Wärmeisolierung 7 bzw. Wärmeisoliereinheit soll anzeigen, dass eine solche nicht in jedem Fall erforderlich ist.

FIG 9 zeigt einen beispielhaften Aufbau eines erfindungsgemässen Gefahrenmelders 1 am Beispiel eines Brandmelders nach einer dritten Ausführungsform.

Im Gegensatz zur Ausführungsform gemäss FIG 8 erfolgt hier die räumlich vertikal getrennte Anordnung der gesamten vollständig wärmeisolierten, aufgeheizten "Elektronik" von der Detektoreinheit 3 im Brandmelder 1 selbst. Zur verbesserten thermischen Entkopplung sind zudem die wärmeisolierten Bauelemente 5, 6 auf der dem Meldersockel 11 zugewandten Bestückungsseite des Schaltungsträgers 4 angeordnet. Dadurch wird vorteilhaft die aus der Wärmeisolierung 7 nach aussen abgeführte Restwärme der Thermik folgend nach oben und dann über den typischerweise kalten Deckenbereich abgeführt, so dass eine thermische nachteilige Einkopplung der Restwärme zur Detektoreinheit 3 nahezu ausgeschlossen werden kann.

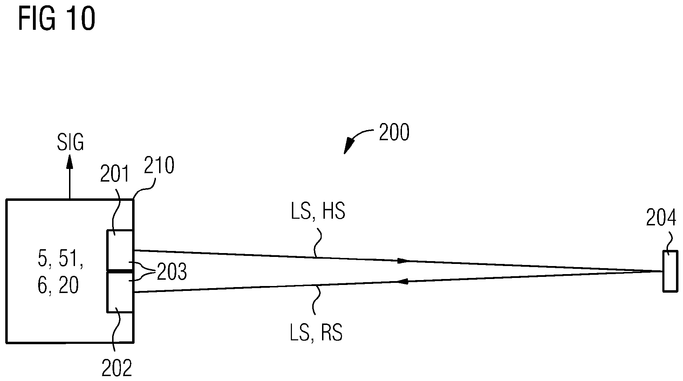

FIG 10 zeigt ein Beispiel für einen als linearen Rauchmelder 200 ausgebildeten Gefahrenmelder 1 gemäss der Erfindung mit einer Umlenkeinheit 204 und einer Rauchmeldereinheit 210.

Im vorliegenden Beispiel liegen sich die typischerweise als Baueinheit ausgeführte Rauchmeldereinheit 210 und die Umlenkeinheit 204 gegenüber. Gemäss der Erfindung weist die Rauchmeldereinheit 210 die Detektoreinheit 203 zur Detektion der zumindest einen Gefahrenkenngrösse auf. Letztere ist typischerweise eine Mindestrauchdichte oder eine Mindestrauchpartikeldichte. Die Detektoreinheit 203 umfasst ihrerseits einen Lichtsender 201 zur Aussendung eines eine Messstrecke durchquerenden Lichtstrahls LS und einen benachbart angeordneten Lichtempfänger 202 zum Empfangen des ausgesendeten Lichtstrahls LS am Ende der Messstrecke. Der Lichtsender 201 sendet vorzugsweise stark gebündeltes infrarotes Licht aus, wie z.B. mittels eines IR-Lasers oder eine IR-Leuchtdiode. Der Lichtempfänger 202 ist sensitiv für das zu empfangende Licht. Er ist z.B. eine IR-Photodiode oder ein IR-Fototransistor. Die Umlenkeinheit 204 ist im vorliegenden Fall ein Umlenkprisma. Es kann alternativ ein Spiegel oder ein sogenannter Retroreflektor im Sinne eines Katzenauges sein. Die Umlenkeinheit 204 ist dabei zur Umlenkung des vom Lichtsender 201 ausgesandten Lichtstrahls LS zurück auf den Lichtempfänger 202 vorgesehen.

Im vorliegenden Beispiel setzt sich der Lichtstrahl LS aus einem Hinstrahl HS und aus einem Rückstrahl RS zusammen, die in etwa antiparallel zueinander verlaufen. Die dabei vom Lichtstrahl LS durchlaufende Messstrecke setzt sich dabei streckenmässig aus der Länge des Hinstrahls HS und der Länge des Rückstrahls RS, also dem doppelten Abstand zwischen der Rauchmeldereinheit 210 und der Umlenkeinheit 204, zusammen. Weiterhin gemäss der Erfindung weist die Rauchmeldereinheit 210 das zumindest eine Halbleiterbauelement 5 und die weiteren elektrischen Bauelemente 6 zumindest zur Ausgabe des Meldersignals SIG auf. Dabei weist diese auch den Temperaturregelkreis 20 auf, der dazu eingerichtet ist, die Temperatur des zumindest einen Halbleiterbauelementes 5 zu regeln, insbesondere auf eine vorgegebene, vorzugsweise annähernd konstante Betriebstemperatur in einem Bereich von 60°C bis 160°C, insbesondere von 80°C bis 125°C.

Dadurch ist im Vergleich zum Stand der Technik ein längerer Einsatz des linearen Rauchmelders 200 im Bereich mit erhöhter radioaktiver Strahlendisposition möglich, wie z.B. im sogenannten Sperrbereich NUC eines Kernreaktors in einem Kernkraftwerk.

Alternativ - figürlich nicht dargestellt - können der Lichtsender und der Lichtempfänger auch räumlich getrennt voneinander angeordnet sein. In diesem Fall ist auch keine Umlenkeinheit erforderlich. An der Stelle der gezeigten Umlenkeinheit ist dann der Lichtsender angeordnet und auf den gegenüberliegenden Lichtempfänger ausgerichtet. In diesem Fall entspricht der Abstand zwischen dem Lichtsender und dem Lichtempfänger zugleich der Messstrecke.

### Bezugszeichenliste

- 1: Gefahrenmelder, Brandmelder, Linearer Rauchmelder
- 2: Meldezentrale, Gefahrenmeldezentrale, Panel
- 3: Detektoreinheit, Branddetektoreinheit, optische Messkammer
- 4: Schaltungsträger, Leiterplatte
- 5: Halbleiterbauelement
- 6: weiteres elektrisches Bauelement
- 7: Wärmeisolierung, thermische Isoliereinheit
- 8: elektrischer Anschluss
- 9: Gassensor, Gas-FET
- 11: Meldersockel, Anschlussplatte
- 12: Gehäusegrundkörper
- 13: Gehäuseabdeckung, Gehäusekappe
- 14: sockelseitiger Anschluss
- 15: melderseitiger Anschluss
- 20: Temperaturregelkreis
- 21: Temperatursensor
- 22: Vergleicher, Differenzbildner, Subtrahierer
- 23: Regler
- 24: Stellglied

- 31: Gassensor-Detektoreinheit
- 32: Hitze-Detektoreinheit, NTC
- 51: Mikrocontroller
- 70: Heizelement, Widerstand, Flächenheizelement
- 71: Wärmeisolierhalbschale
- 72: Wärmeisolierplatte
- 73: Wärmeisolierkapsel
- 74: thermisch stabiler Schaltungsträger
- 100: Gefahrenmeldeanlage, Brandmeldeanlage
- 200: Linearer Rauchmelder (LRM)
- 201: Lichtsender, Laser, Laserdiode
- 202: Lichtempfänger, Photodiode
- 203: Detektoreinheit
- 204: Umlenkeinheit, Reflektor, Retroreflektor
- 210: Rauchmeldereinheit
- ADR: Melderadresse
- ADR1-ADR3: Auswahladresse
- HS: Hinstrahl
- IN: Eingänge
- LS: Lichtstrahl
- M-PRG: Hauptprogramm
- NUC: Bereich mit erhöhter Radioaktivität, Nuklearbereich
- OF: Gehäuseöffnung
- OUT: Ausgänge
- PV: Sollwert für Verlustleistung
- PV-PRG: Verlustleistungssteuerprogramm
- RS: Rückstrahl
- SIG: Meldersignal, Alarmmeldung
- TC-PRG: Temperaturregelprogramm
- TI: Temperaturistwert
- TS: Temperatursollwert
- W: Wärme
- T: Temperaturerfassung

## Patentansprüche

1. Gefahrenmelder, insbesondere Brandmelder, zum Betrieb innerhalb eines Kernkraftwerkes (NUC), einer kerntechnischen Wiederaufbereitungsanlage oder eines End- oder Zwischenlagers für radioaktiven Abfall, wobei der Gefahrenmelder (1) zumindest eine Detektoreinheit (3, 203) zur Detektion zumindest einer Gefahrenkenngrösse, ein Halbleiterbauelement (5) und weitere elektrische Bauelemente (6) zumindest zur Ausgabe eines Meldersignals (SIG) aufweist, **dadurch gekennzeichnet,**
**dass** der Gefahrenmelder einen Temperaturregelkreis (20) aufweist, dass der Temperaturregelkreis (20) dazu eingerichtet ist, die Temperatur des zumindest einen Halbleiterbauelementes (5) zu regeln, wobei das zumindest eine Halbleiterbauelement (5) ein prozessorgestützter Mikrocontroller (51) ist, wobei ein Computerprogramm (TC-PRG) als Teil des Temperaturregelkreises (20) und ein weiteres Computerprogramm (PV-PRG) auf dem Mikrocontroller (51) ausgeführt werden
und wobei das weitere Computerprogramm (PV-PRG) ausgeführt ist, die elektrische Verlustleistung des Mikrocontrollers (51) und/oder zumindest eines durch den Mikrocontroller (51) ansteuerbaren weiteren Halbleiterbauelementes (5) in Abhängigkeit der erfassten Temperatur des Halbleiterbauelementes (5, 51) im Sinne einer Heizung (70) zu steuern.

2. Gefahrenmelder nach Anspruch 1, wobei der Temperaturregelkreis (20) ein insbesondere elektrisches Heizelement (70) zum geregelten Beheizen des zumindest einen Halbleiterbauelementes (5) aufweist.

3. Gefahrenmelder nach Anspruch 1 oder 2 wobei der Temperaturregelkreis (20) zur Regelung auf eine vorgegebene, vorzugsweise annähernd konstante Betriebstemperatur in einem Bereich von 60°C bis 160°C, insbesondere von 80°C bis 125°C, eingerichtet ist.

4. Gefahrenmelder nach einem der vorigen Ansprüche, wobei das zumindest eine Halbleiterbauelement (5) thermisch von der Detektoreinheit (3) entkoppelt ist.

5. Gefahrenmelder nach Anspruch 4, wobei die Detektoreinheit (3) räumlich getrennt von dem zumindest einen Halbleiterbauelement (5) angeordnet ist.

6. Gefahrenmelder nach einem der vorigen Ansprüche, wobei die Detektoreinheit (3) dazu eingerichtet ist, eine physikalische Eigenschaft der angrenzenden Umgebungsluft erfassen und wobei die Detektoreinheit (3) vom zumindest einen Halbleiterbauelement (5) thermisch entkoppelt ist.

7. Gefahrenmelder nach einem der vorherigen Ansprüche, wobei der Gefahrenmelder eine Wärmeisolierung (7) zumindest für das zumindest eine Halbleiterbauelement (5) aufweist.

8. Gefahrenmelder nach einem der vorherigen Ansprüche, wobei der Gefahrenmelder ein derart ausgestaltetes Gehäuse (11, 12) aufweist, dass die im Bereich (NUC) mit erhöhter radioaktiver Strahlung auf den Gefahrenmelder auftreffende radioaktive Teilchenstrahlung im Wesentlichen abgeschirmt wird.

## Claims

1. Hazard alarm, in particular a fire alarm, for operation within a nuclear power station (NUC), a nuclear reprocessing plant or a final or intermediate storage facility for radioactive waste, wherein the hazard alarm (1) has at least one detector unit (3, 203) for detecting at least one hazard characteristic, a semiconductor component (5) and other electrical components (6) at least for outputting an alarm signal (SIG), **characterised in that**
the hazard alarm has a temperature control circuit (20) and that the temperature control circuit (20) is configured to control the temperature of the at least one semiconductor component (5), wherein the at least one semiconductor component (5) is a processor-backed microcontroller (51), wherein a computer program (TC-PRG) as part of the temperature control circuit (20) and a further computer program (PV-PRG) are executed on the microcontroller (51) und wherein the further computer program (PV-PRG) is designed to control the electrical power dissipation of the microcontroller (51) and/or at least one of the other semiconductor components (5) which can be controlled by the microcontroller (51) in accordance with the detected temperature of the semiconductor component (5, 51) in the sense of a heating system (70).

2. Hazard alarm according to claim 1, wherein the temperature control circuit (20) has in particular an electrical heating element (70) for controlled heating of the at least one semiconductor component (5).

3. Hazard alarm according to claim 1 or 2, wherein the temperature control circuit (20) is configured to control to a specified, preferably approximately constant operating temperature in a range from 60°C to 160°C, in particular from 80°C to 125°C.

4. Hazard alarm according to one of the preceding claims, wherein the at least one semiconductor component (5) is thermally decoupled from the detector unit (3).

5. Hazard alarm according to claim 4, wherein the detector unit (3) is arranged so as to be spatially separated from the at least one semiconductor component (5).

6. Hazard alarm according to one of the preceding claims, wherein the detector unit (3) is configured to detect a physical characteristic of the adjacent ambient air and wherein the detector unit (3) is thermally decoupled from the at least one semiconductor component (5).

7. Hazard alarm according to one of the preceding claims, wherein the hazard alarm has thermal insulation (7) at least for the at least one semiconductor component (5).

8. Hazard alarm according to one of the preceding claims, wherein the hazard alarm has a housing (11, 12) that is designed in such a way that in the area (NUC) with increased radioactive radiation, the radioactive particle radiation striking the hazard alarm is essentially screened off.

## Revendications

1. Avertisseur de danger, en particulier détecteur d'incendie, destiné à fonctionner au sein d'une centrale nucléaire (NUC), d'une installation de retraitement nucléaire ou d'un site de stockage final ou intermédiaire pour des déchets radioactifs, dans lequel l'avertisseur de danger (1) présente au moins une unité de détection (3, 203) destinée à la détection d'au moins une caractéristique spécifique de danger, un composant semi-conducteur (5) et des composants électriques supplémentaires (6) destinés au moins à l'émission d'un signal d'avertissement (SIG), **caractérisé en ce que** l'avertisseur de danger présente un circuit de réglage de température (20), **en ce que** le circuit de réglage de température (20) est conçu pour régler la température de l'au moins un composant semi-conducteur (5), dans lequel l'au moins un composant semi-conducteur (5) est un microcontrôleur informatique (51), dans lequel un programme informatique (TC-PRG) est exécuté dans le cadre du circuit de réglage de température (20) et un programme informatique supplémentaire (PV-PRG) est exécuté sur le microcontrôleur (51) et dans lequel le programme informatique supplémentaire (PV-PRG) est exécuté pour commander la perte de puissance électrique du microcontrôleur (51) et/ou d'au moins un composant semi-conducteur supplémentaire (5) qui peut être commandé par le biais du microcontrôleur (51) en fonction de la température acquise du composant semi-conducteur (5, 51) en termes de chauffage (70).

2. Avertisseur de danger selon la revendication 1, dans lequel le circuit de réglage de température (20) présente un élément chauffant en particulier électrique (70) destiné au chauffage réglé de l'au moins un composant semi-conducteur (5).

3. Avertisseur de danger selon la revendication 1 ou 2, dans lequel le circuit de réglage de température (20) est conçu pour un réglage sur une température de fonctionnement prédéterminée, de préférence à peu près constante dans une plage de 60°C à 160°C, en particulier de 80°C à 125°C.

4. Avertisseur de danger selon l'une des revendications précédentes, dans lequel l'au moins un composant semi-conducteur (5) est découplé thermiquement de l'unité de détection (3).

5. Avertisseur de danger selon la revendication 4, dans lequel l'unité de détection (3) est disposée séparée dans l'espace de l'au moins un composant semi-conducteur (5).

6. Avertisseur de danger selon l'une des revendications précédentes, dans lequel l'unité de détection (3) est conçue pour acquérir une propriété physique de l'air ambiant adjacent et dans lequel l'unité de détection (3) est découplée thermiquement de l'au moins un composant semi-conducteur (5).

7. Avertisseur de danger selon l'une des revendications précédentes, dans lequel l'avertisseur de danger présente une isolation thermique (7) au moins pour l'au moins un composant semi-conducteur (5).

8. Avertisseur de danger selon l'une des revendications précédentes, dans lequel l'avertisseur de danger présente un boîtier (11, 12) configuré de telle sorte que le rayonnement de particules radioactives frappant l'avertisseur de danger dans la zone (NUC) avec un rayonnement radioactif augmenté est pour l'essentiel protégé.
